(19) Europäisches Patentamt
European Patent Office
Office européen des brevets

(11) EP 0 697 744 B1

(12) **EUROPÄISCHE PATENTSCHRIFT**

(45) Veröffentlichungstag und Bekanntmachung des Hinweises auf die Patenterteilung:
**05.01.2000 Patentblatt 2000/01**

(51) Int Cl.$^7$: **H01L 33/00**

(21) Anmeldenummer: **95202173.1**

(22) Anmeldetag: **10.08.1995**

(54) **Organisches, elektrolumineszentes Bauteil**

Organic electroluminescent device

Dispositif électroluminescent organique

(84) Benannte Vertragsstaaten:
**DE FR GB NL**

(30) Priorität: **11.08.1994 DE 4428450**
**17.08.1994 EP 94202340**

(43) Veröffentlichungstag der Anmeldung:
**21.02.1996 Patentblatt 1996/08**

(73) Patentinhaber:
- **Philips Patentverwaltung GmbH**
  **22335 Hamburg (DE)**
  Benannte Vertragsstaaten:
  **DE**
- **Koninklijke Philips Electronics N.V.**
  **5621 BA Eindhoven (NL)**
  Benannte Vertragsstaaten:
  **FR GB NL**

(72) Erfinder:
- **Boerner, Herbert, Dr.**
  **D-22335 Hamburg (DE)**
- **Kynast, Ulrich, Dr.**
  **D-22335 Hamburg (DE)**
- **Busselt, Wolfgang**
  **D-22335 Hamburg (DE)**
- **Haase, Markus, Dr.**
  **D-22335 Hamburg (DE)**

(74) Vertreter: **Volmer, Georg, Dipl.-Ing. et al**
**Philips Patentverwaltung GmbH,**
**Röntgenstrasse 24**
**22335 Hamburg (DE)**

(56) Entgegenhaltungen:
**US-A- 5 128 587**

- **INTERNATIONAL CONFERENCE, RARE EARTHS '92, KYOTO, JAPAN, 1-5 JUNE 1992, Bd. 192, Nr. 1-2, ISSN 0925-8388, JOURNAL OF ALLOYS AND COMPOUNDS, 23 FEB. 1993, SWITZERLAND, Seiten 30-33, KIDO J ET AL 'Organic electroluminescent devices using lanthanide complexes'**
- **INTERNATIONAL CONFERENCE ON SCIENCE AND TECHNOLOGY OF SYNTHETIC METALS (ICSM '94), SEOUL, SOUTH KOREA, 24-29 JULY 1994, Bd. 71, Nr. 1-3, ISSN 0379-6779, SYNTHETIC METALS, 1 APRIL 1995, SWITZERLAND, Seiten 2099-2100, TAKADA N ET AL 'Strongly-directed emission from microcavity structure in electroluminescent diodes with europium complex as an emitter'**
- **PATENT ABSTRACTS OF JAPAN Bd. 016, Nr. 120 (E-1182) 26 M{rz 1992 & JP-A-03 289089 (MITSUI TOATSU CHEM INC) 19 Dezember 1991**
- **APPLIED PHYSICS LETTERS, 24 OCT. 1994, USA, Bd. 65, Nr. 17, ISSN 0003-6951, Seiten 2124-2126, KIDO J ET AL 'Bright red light-emitting organic electroluminescent devices having a europium complex as an emitter'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein organisches, elektro-lumineszentes Bauteil, z.B. Elektrolumineszensdioden (LED) für Leuchtanzeigen, Leuchten, Festkörperbildverstärker, Hochleistungsmonitore oder Fernsehbildschirme.

LEDs nach dem Stand der Technik sind in der Regel Halbleiterdioden, also Dioden für deren Aufbau anorganische Halbleiter wie dotiertes Zinksulfid, Silizium, Germanium oder III-V-Halbleiter, z.B. InP, GaAs, GaAlAs, GaP oder GaN mit entsprechenden Dotierungen verwendet werden. Diese Halbleiterdioden enthalten eine p-dotierte Kristallzone und eine n-dotierte Kristallzone. In einer typischen Ausführung erzeugt man zunächst durch entsprechende Dotierung des Halbleiters einen n-leitenden Grundkristall. Auf diesen läßt man eine nur 1µm dicke p-Zone mit hohem Dotierungsgrad, d.h. großer Löcherdichte, aufwachsen.

Die p-Schicht wird mit einer durchsichtigen Elektrode abgedeckt, die n-Schicht mit einer normalen Metallelektrode. Beim Anlegen einer Spannung in Durchlaßrichtung wandern Elektronen aus dem n-Gebiet und Löcher aus dem p-Gebiet in die pn-Grenzschicht und rekombinieren dort, d.h. die Elektronen füllen die Löcher im Valenzband auf. Die bei der Rekombination freiwerdende Energie wird in Form von Lichtquanten abgestrahlt. Die Farbe des abgestrahlten Lichtes hängt vom verwendeten Halbleiter und dessen Dotierung ab.

Seit einigen Jahren wird an der Entwicklung von Lumineszensstrahlungsquellen gearbeitet, deren Emittermaterial kein anorganischer Halbleiter, sondern ein organisches, elektrisch leitendes Material ist.

Elektrolumineszente Bauteile mit leuchtenden Schichten, die aus organischen Materialien aufgebaut sind, sind Lichtquellen aus anorganischen Materialien in einigen Eigenschaften deutlich überlegen. Ein Vorteil ist ihre leichte Formbarkeit und hohe Elastizität, die etwa für Leuchtanzeigen und Bildschirme neuartige Anwendungen ermöglicht. Diese Schichten können leicht als großflächige, flache und sehr dünne Schichten hergestellt werden, für die zudem der Materialeinsatz gering ist. Sie zeichnen sich auch durch eine bernerkenswert große Helligkeit bei gleichzeitig kleiner Ansteuerspannung aus.

Weiterhin kann die Farbe des emittierten Lichtes durch Wahl der lumineszierenden Substanz in weiten Bereichen von ca. 400 nm bis ca. 650 nm variiert werden. Diese Farben fallen durch ihre Luminanz auf.

Man hat auch schon Kombinationen von elektrisch leitenden organischen Materialien mit metallo-organischen Verbindungen der Seltenerdmetalle für Lumineszenzstrahlungsquellen eingesetzt. Aus der US-A-5128587 ist ein elektrolumineszierendes Bauteil bekannt, das eine Schichtenfolge umfasst aus (a) einem Substrat, das transparent für sichtbares Licht ist, (b) einer ersten Elektrode, die transparent für sichtbares Licht ist, (c) einer p-leitenden Schicht, die transparent für sichtbares Licht ist, (d) eine Lumineszensschicht, die metallo-organische Komplexe der Lanthanoiden enthält und (e) eine zweite Elektrode. Dabei kann die p-leitende Schicht ein organischer oder anorganischer Halbleiter von p-Typ sein und die metallo-organischen Komplexe können in eine Membran eingebettet sein, die aus Verbindungen besteht, die mit dem angeregten Zustand des besagten metallo-organischen Komplexes einen Anlagerungskomplex bilden können. Ein derartiges elektrolumineszierendes Bauteil zeichnet sich durch monochromatische Strahlung aus.

Weiterhin ist aus Journal of Alloys and Compounds, Bd. 192 (1993), CH, S. 30-33; J. Kido et al.: "Organic electroluminescent devices using lanthanide complexes" ein organisches elektrolumineszentes Bauteil mit einem Schichtverbund aus a) einer Substratschicht, b) einer ersten transparenten Elektrodenschicht, c) einer oder mehreren optoelektronisch funktionellen Schichten mit

c.1) gegebenenfalls einem oder mehreren p-leitenden, organischen Materialien mit ein oder mehreren Singulett-zuständen und ein oder mehreren Triplett-Zuständen und
c.2) einem lumineszenzierenden Material mit einem oder mehreren Komplexen eines Seltenerdmetallions mit organischen Liganden, wobei sowohl das Seltenerdmetallion einen emittierenden Zustand und die organischen Liganden ein oder mehrere Singulett-Zustände und ein oder mehrere Triplett-Zustände haben und
c.3) einem oder mehreren n-leitenden, organischen Materialien mit ein oder mehreren Singulett-Zuständen und ein oder mehreren Triplett-Zuständen und

d) einer zweiten Elektrode bekannt.

Ein Nachteil der oben genannten Bauteile ist ihr geringer Wirkungsgrad. Nach den bekanntgewordenen Ergebnissen verschiedener Arbeitsgruppen wurden bei den ersten Prototypen weniger als einige Tausendstel der zugeführten Leistung in Licht umgewandelt, inzwischen konnte die Effizienz für die interne Quantenausbeute auf etwa 4% (Nature, Bd.365, S.628), die externe Quantenausbeute auf 4,2% (J.Appl.Phys.72,1957(1992)) gesteigert werden.

Der geringe optische Wirkungsgrad der bekannten elektrolumineszierenden Bauteile mit organischen Materialien geht zudem einher mit einer erhöhten thermischen Belastung der Bauteile durch Ladungstransport und nichtstrahlende Übergänge, die die Bauteile mit der Zeit zerstört.

Es ist deshalb die Aufgabe der Erfindung, ein organisches, elektrolumineszierendes Bauteil mit elektrisch leitenden, organischen Materialien und metallo-organischen Komplexen der Seltenerdmetallen mit hoher Lichtausbeute und langer Lebensdauer zur Verfügung zu stellen.

Erfindungsgemäß wird die Aufgabe gelöst durch ein organisches, elektrolumineszentes Bauteil mit einem Schichtverbund aus

a) einer Substratschicht
b) einer ersten transparenten Elektrodenschicht,
c) einer oder mehreren optoelektronisch funktionellen Schichten mit

c.1) gegebenenfalls einem oder mehreren p-leitenden, organischen Materialien mit ein oder mehreren Singulett-Zuständen und ein oder mehreren Triplett-Zuständen und
c.2) einem lumineszenzierenden Material mit einem oder mehreren metallo-organischen Komplexen eines Seltenerdmetallions mit organischen Liganden, wobei das Seltenerdmetallion einen emittierenden Zustand und die organischen Liganden ein oder mehrere Singulett-Zustände und ein oder mehrere Triplett-Zustände haben und
c.3) einem oder mehreren n-leitenden, organischen Materialien mit ein oder mehreren Singulett-Zuständen und ein oder mehreren Triplett-Zuständen und

d) einer zweiten Elektrode,

wobei der energetisch niedrigste Triplett-Zustand der Liganden niedriger als die energetisch niedrigsten Triplett-Zustände der n-leitenden und der p-leitenden, organischen Materialien und über dem emittierenden Zustand des Seltenerdmetallions liegt.
Die Erfindung beruht auf dem Gedanken, daß es möglich gemacht werden soll, die Lichtausbeute von organischen, elektrolumineszenten Bauteilen dadurch zu erhöhen, daß von den bei der Rekombination von Elektronen und Löchern entstehenden Excitonen nicht nur wie beim Stand der Technik die Singulett-Excitonen sondern auch die Triplett-excitonen für die Lichtanregung nutzbar gemacht werden.
Ein erfindungsgemäßes organisches elektrolumineszentes Bauteil zeichnet sich daher durch eine überraschend erhöhte Lichtausbeute aus, außerdem weist es eine sehr gute thermische Stabilität auf und läßt sich mit einfachen Verfahren herstellen.
Im Rahmen der vorliegenden Erfindung ist es bevorzugt, daß ein p-leitendes organisches Material und das lumineszenziernde Material in einer ersten, homogenen Schicht enthalten sind und ein n-leitendes organisches Material in einer zweiten Schicht enthalten ist, wobei der niedrigste Triplett-Zustand des p-leitenden organischen Materials niedriger liegt als derjenige des n-leitenden organischen Materials.
In einem derartigen Schichtverbund mit einer multifunktionellen Schicht, die den p-Leiter und das lumineszierende Material mit der angegebenen relativen Lage der Energiezustände enthält, haben die lumineszenzerzeugenden Vorgänge einen besonders hohen Wirkungsgrad.
Es kann weiterhin bevorzugt sein, daß ein p-leitendes organisches Material in einer ersten Schicht enthalten ist und ein n-leitendes organisches Material und das lumineszenziernde Material in einer zweiten, homogenen Schicht enthalten sind, wobei der niedrigste Triplett-Zustand des n-leitenden organischen Materials niedri ger liegt als derjenige des p-leitenden organischen Materials.
Auch diese Konfiguration zeigt eine sehr gute Lichtausbeute.
Es kann auch bevorzugt sein, daß ein p-leitendes organischen Material mit dem lumineszierenden Material in einer ersten homogenen Schicht und ein n-leitendes organisches Material mit dem lumineszierenden Material in einer zweiten homogenen Schicht enthalten sind.
Bei etwa gleicher Lage der Energieniveaus für die Triplett-Zustände der organischen Materialien zeigt diese Konfiguration den besten Wirkungsgrad. Außerdem ergibt sich dadurch eine gute Materialverträglichkeit im Schichtverbund.
Besonders einfach zu fertigen ist eine Ausführungsform der Erfindung, bei der ein oder mehrere p-leitende organische Materialien, das elektrolumineszierende Material und ein oder mehrere n-leitende organische Materialien in einer homogenen Schicht enthalten sind, wobei die Redoxpotentiale der n- und p-leitenden Materialien größer als die des elektrolumineszierenden Materials sind.
Es kann im Rahmen der vorliegenden Erfindung auch bevorzugt sein, daß ein oder mehrere p-leitende, organische Materialien, ein oder mehrere n-leitende organische Materialien und das lumineszierende Material jeweils in einer separaten Schicht angeordnet sind, wobei die Schicht mit dem lumineszierenden Material zwischen der Schicht mit dem oder den p-leitenden organischen Materialien und der Schicht mit dem oder den n-leitenden Materialien liegt.
Die Eigenschaften der drei funktionellen Schichten sind in dieser Ausführungsform separat optimierbar. Dabei kann die Schicht mit dem lumineszierenden Material besonders dünn ausgebildet werden, wodurch die externe Lichtausbeute gesteigert wird.
Die p-leitenden organischen Materialien können ein molekular dotiertes organisches Polymer, ein halbleitendes konjugiertes Polymer, ein intrinsisch leitendes organisches Polymer oder ein p-leitendes organisches Monomer oder deren Gemische sein.

Eine besonders bevorzugte Ausführungsform ist dadurch gekennzeichnet, daß das p-leitende, organische Material aus den organischen Liganden des Seltenerdmetallions besteht. In dieser Ausführungsform erfolgt die Rekombination von positiven und negativen Ladungsträgern direkt auf dem Liganden. Durch diese direkte Energieübertragung erhält man eine verbesserte Ausbeute.

Die n-leitenden organischen Materialien können ein molekular dotiertes organisches Polymer, ein intrinsisch leitendes organisches Polymer oder ein n-leitendes organisches Monomer oder deren Gemische sein.

Besonders die molekular dotierten organischen Polymere, sowohl die p-leitenden als auch die n-leitenden, erlauben eine getrennte Optimierung von thermischen und elektrischen Eigenschaften.

Schichten mit Monomeren haben den Vorteil, daß sie besonders leicht herstellbar sind, da sie in der Regel in einem Aufdampfverfahren aufgebracht werden können.

Es ist weiterhin bevorzugt, daß die Liganden des Seltenerdmetallions chelatisierende Sauerstoff-, Schwefel- oder Stickstoffliganden sind. Derartige Komplexe zeichnen sich durch intensive Energieübertragung und durch die Darstellbarkeit reiner Farben aus.

In einer bevorzugten Ausführungsform des organischen, elektrolumineszenten Bauteils ist das p-leitende organische Material Poly(N-Vinylcarbazol), der Komplex des Seltenerdmetall ions Europium-(III)-Phenantrolin-tri-thenoyltrifluoroacetylacetonat ($Eu(ttfa)_3phen$) und das n-leitende Material 2-(4-Biphenylyl)-5-phenyl-1,3,4-oxadiazol (PBD).

In einer anderen bevorzugten Ausführungsform ist das p-leitende organische Material Poly(N-Vinylcarbazol), der Komplex des Seltenerdmetallions Terbium(III)-di-bipyridyl-tribenzoat ($Tb(benz)_3bipy_2$) und das n-leitende organische Material 2-(4-Biphenylyl)-5-phenyl-1,3,4-oxadiazol (PBD).

Im folgenden wird die Erfindung anhand von Zeichnungen und Beispielen weiter erläutert.

**Fig. 1** zeigt den prinzipiellen Aufbau eines organischen elektrolumineszenten Bauteils nach der Erfindung mit zwei optoelektronisch funktionellen Schichten.

**Fig. 2** zeigt eine andere Ausführungsform der Erfindung mit zwei optoelektronisch funktionellen Schichten.

**Fig. 3** zeigt eine weitere Ausführungsform der Erfindung mit zwei optoelektronisch funktionellen Schichten.

**Fig. 4** zeigt eine weitere Ausführungsform der Erfindung mit drei optoelektronisch funktionellen Schichten.

Das erfindungsgemäße organische elektrolumineszierende Bauteil besteht aus einem Schichtverbund aus einer Substratschicht **1**, einer ersten, transparenten Elektrodenschicht **2**, einer oder mehreren Schichten **3** mit gegebenenfalls einem p-leitenden, organischen Material **31**, mit einem lumineszenzierenden Material mit einem oder mehreren Komplexen eines Seltenerdmetallions mit organischen Liganden **32** und n-leitenden, organischen Material **33** sowie einer zweiten Elektrode **4**.

Im Betrieb wird eine Gleichstromspannung an die beiden Elektroden angelegt. Dabei liegt die erste Elektrode auf positivem Potential (Anode), die zweite auf negativem Potential (Kathode).

Üblicherweise besteht die optoelektronische Zwischenschicht **3** aus zwei separaten Schichten für das p-leitende d.h. löcherleitende Material **31** und das n-leitende d.h. elektronenleitende Material **33**. Dabei kann entweder die p-leitende Schicht wie in **Fig.2** oder die n-leitende Schicht wie in **Fig. 1** oder beide wie in **Fig.3** auch das elektrolumineszierende Material **32** mit einem oder mehreren Komplexen eines Seltenerdmetallions mit organischen Liganden enthalten.

In einer weiteren Ausführungsform gemäß **Fig.4** sind die drei Materialien in drei separaten Schichten angeordnet - Löcherleiter, Lumineszenzschicht, Elektronenleiter.

Wie die Abbildungen zeigen, dient als Substrat **1** immer eine Platte aus einem lichtdurchlässigen Material, beispielsweise eine Glasplatte. Darauf ist als dünner Film von einigen 100 nm Dicke die Anode **2** aufgebracht, die ebenfalls lichtdurchlässig sein muß. Darauf folgen die p- und dann die n-leitende Schicht bzw. die kombinierte Schicht mit p-und n-leitendem Material sowie die elektrolumineszente Schicht. Die Dicken dieser Schichten liegen zwischen 10 und 100 nm. Vervollständigt wird das organische, elektrolumineszente Bauteil durch die Kathode **4**.

Als Material für die transparente Anode, von der aus Löcher in die p-leitende Schicht injiziert werden, sind Metalle, Metalloxide oder elektrisch leitende organische Polymere mit hoher Austrittsarbeit für Elektronen geeignet. Beispiele sind dünne, transparente Schichten aus indiumdotiertem Zinnoxid (ITO), Gold oder Polyanilin.

Für die p-leitende Schicht werden molekular dotierte organische Polymere, intrinsisch leitende organische Polymere, d.h. Polymere mit Eigenleitfähigkeit oder leitfähige organische Monomere verwendet. Voraussetzung ist, daß der niedrigste Triplett-Zustand dieser Polymere bzw. Monomere höher liegt als derjenige der Liganden des Seltenerdmetallkomplexes: $T_1^p > T_1^L$, wobei $T_1^p$ der niedrigste Triplett-Zustand des p-leitenden, organischen Polymeren und $T_1^L$ der niedrigste Triplett-zustand des Liganden des Seltenerdmetallkomplexes ist.

Ein Beispiel für ein intrinsisch p-leitendes, organisches Polymeres ist Poly(N-Vinylcarbazol) mit $T_1^p$ von ca. 23 000 $cm^{-1}$.

Traditionell dienen organische Polymere wegen ihrer meist verschwindend geringen elektrischen Leitfähigkeit

als Isolatoren oder Ummantelungen in der Elektro- und Elektronikindustrie. In jüngster Zeit ist es jedoch gelungen, die Leitfähigkeit von organischen Polymeren durch Dotierungen, also durch Einbringen genau definierter Verunreinigungen, so zu modifizieren, daß sie auch als Stromleiter in elektronischen Systemen fungieren können. Solche dotierten organischen Polymere sind z. B. mit Arsenpentafluorid oder Jod dotiertes Polyacetylen. Diese zeigen metallischen Glanz.

Eine andere Klasse von dotierten organischen Polymeren sind die sogenannten "molekular dotierten Polymere" (MDP), wie sie beispielsweise in P.M. Bausenberger und D.S. Weiss, "Organic Photoreceptors for Imaging Systems", Marcel Dekker, New York (1993) beschrieben sind. Dies sind molekulardisperse binäre feste Lösungen von Monomeren, die elektrische Ladungen transportieren können, in inerten, inaktiven polymeren Matrixmolekülen.

Ein ausgezeichnet geeigneter MDP-Werkstoff mit p-leitenden Eigenschaften ist die feste Lösung aus dem p-Leiter N,N'-Diphenyl-N,N'-bis(3-methylphenyl)-1,1'-biphenyl-4,4'-diamin (TPD) als Dotierung in einer Matrix aus Polymethylmetacrylat oder Bisphenol A - Polycarbonat.

Für p-leitende Schichten ohne elektrolumineszierende Zusätze ist auch Poly(p-Phenylenvinylen) und dessen Derivate oder Poly(methylphenylsilan) geeignet. In Schichten mit elektrolumineszierenden Zusätzen stört allerdings deren Fähigkeit zu nichtstrahlenden Übergängen aus dem $T_1$-Zustand.

Als p-leitende organische Monomere können für die vorliegende Erfindung beispielsweise Triphenylamin mit $T_1^p$ von ca. 24 500cm$^{-1}$, Tritoluolamin mit $T_1^p$ von ca. 24 000cm$^{-1}$ oder Triphenyldiamin mit $T_1^p$ von ca. 18 000cm$^{-1}$ verwendet werden. Ebenfalls geeignet sind Verbindungen der Zusammensetzung

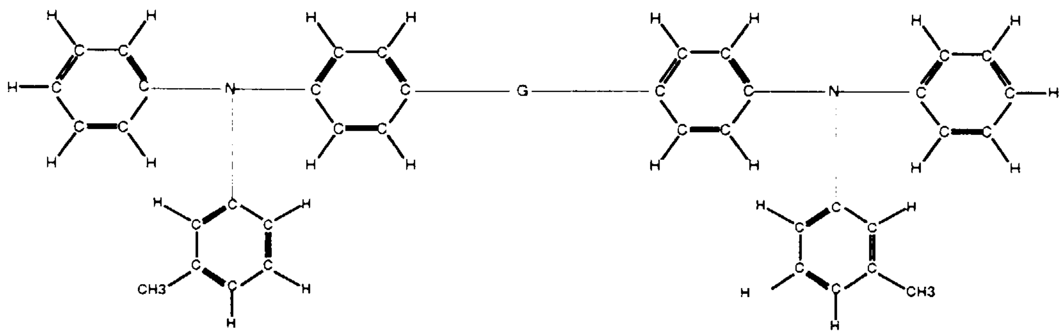

mit G = Cyclohexylen, - $(CH_2)_n$- und - $(CF_2)_n$- mit n = 1,2, 3, 4, 5. Diese p-Leiter haben ein Triplett mit $T_1^p$ von ca. 24 000 cm$^{-1}$.

Für die Schicht mit n-Leitung werden ebenfalls intrinsisch leitende organische Monomere und Polymere oder mit molekularer Dotierung versehene Polymere eingesetzt. Intrinsisch leitende organische Monomere, die für die elektronentransportierende Schicht geeignet sind, sind 3,4,9,10-Perylen-tetracarboxy-bis-benzimidazol, 2-(4-Biphenylyl)-5-(tert.-butylphenyl)-1,3,4-oxadiazol (butyl-PBD), 2-(4-Biphenylyl)-5-phenyl-1,3,4-oxadiazol (PBD) mit $T^1_n$ von ca. 20 500 cm$^{-1}$ oder 2,5-Diphenyl-1,3,4-oxadiazol (PPD) mit $T^1_n$ von ca. 23 500 cm$^{-1}$ und 8-Hydroxychinolin-Aluminium ($Alq_3$).

Als n-leitendes molekular dotiertes organisches Polymere kann ein mit 8-Hydroxychinolin-Aluminium ($Alq_3$) versetztes Polymethyl-metacrylat verwendet werden.

Weitere molekular dotierte organische Polymere, die erfindungsgemäß verwendet werden können, setzen sich beispielsweise aus Polymethyl-methacryl (PMMA), Polystyrol oder Bisphenol A - Polycarbonat als Matrix mit einer Dotierung aus Oxadiazolen wie 2-(4-Biphenylyl)-5-(tert.-butyl-phenyl)-1,3,4-oxadiazol (butyl-PBD)($T_1 \approx 20500$ cm$^{-1}$) und 2,5-Diphenyl-1,3,4-oxadiazol (PPD)($T_1 \approx 23400$ cm$^{-1}$) oder Triazole wie 3,4,5-Triphenyl-1,2,4-triazol und 3-(4'-t-butylphenyl)-4-phenyl-5-(4''-biphenyl)-1,2,4-triazol zusammen.

Wenn nur eine organische Schicht verwendet wird, also p-leitendes und n-leitendes organisches Polymer bzw. Monomer in einer gemeinsamen, homogenen Schicht angeordnet werden, können beispielsweise mit p-leitenden Substanzen und mit n-leitenden Substanzen dotierte molekular dotierte Polymere verwendet werden. Vorteilhaft ist eine Kombination von butyl-PBD in Polymethyl-metacrylat, Polystyrol oder Bisphenol A - Polycarbonat mit anderen Materialien wie Triphenylamin, Triphenyldiamin oder Tritoluolamin.

Das elektrolumineszierende Material enthält einen oder mehrere metallo-organische Komplexe von Seltenerdmetallen mit organischen Sauerstoff-, Schwefel- oder Stickstoff- Liganden. Unter metallo-organischen Komplexen sollen im Rahmen der vorliegenden Erfindung solche Komplexe mit den genannten organischen Liganden verstanden werden, bei denen die Bindung über die Heteroatome erfolgt. Je nach gewünschter Farbe des emittierten Lichtes können auch mehrere Seltenerdmetall-komplexe verwendet werden. Es können auch Seltenerdmetallkomplexe verwendet werden, die nicht sublimierbar oder nicht elektrisch leitend sind.

Das Seltenerdmetallion kann beispielsweise $Eu^{2+}$, $Eu^{3+}$, $Tb^{3+}$, $Tm^{3+}$, $Dy^{3+}$, $Sm^{3+}$, oder $Pr^{3+}$ sein.

Mit Europium- und Samariumkomplexen kann rote, mit den Terbiumkomplexen grüne und mit den Thulium- und Dysprosiumkomplexen blaue Fluoreszenz erzeugt werden.

Besonders geeignet sind Seltenerdmetallkkomplexe der allgemeinen Zusammensetzung $SE[L_1]_3[L_2]_n$. Hierin ist SE ein dreiwertiges Seltenerdmetall-Kation, $L_1$ ein anionischer Ligand, der ein- oder zweizähnig sein kann, und $L_2$ ein neutraler Ligand, der ein- oder zweizähnig sein kann. n wird so gewählt, daß alle Koordinationsstellen des Seltenerdions abgesättigt sind, n kann somit die Werte 0,1,2,3und 4 einnehmen. $L_1$ und $L_2$ sind immer zwei unterschiedliche Liganden. Für $Eu^{2+}$ lautet die entsprechende Formel $Eu[L_1]_2[L_2]_n$.

Als Ligand $L_1$ sind besonders die beta- Diketonate $R_1C(OH)CHCOR_2$ geeignet. Die Reste $R_1$ und $R_2$ können ein $F_3C$-, Thenoyl $C_4H_3S$-, Furanoyl $C_4H_3O$-, t-Butyl und Perfluor-n-propyl $C_3F_7$- sein. Wenn $R_1$ und $R_2$ ein $CF_3$-Rest sind, erhält man das beta- Diketonat Hexafluoracetyl-acetonat (hfa). Wenn $R_1$ und $R_2$ ein t-butyl-Rest sind, erhält man das beta- Diketonat 2,2,6,6,-tetrametyl-3,5-heptandion (thd). Wenn $R_1$ ein Thenoylrest und $R_2$ ein $CF_3$ -Rest ist, erhält man das Betadiketon Thenoyltrifluoro-acetylacetonat (ttfa). Wenn $R_1$ ein Furanoylrest und $R_2$ ein $CF_3$ -Rest ist, erhält man das Betadiketon Furanolyltri-fluoroacetylacetonat (ftfa). Wenn $R_1$ ein t-Butylrest und $R_2$ ein Perfluor-n-propyl-Rest ist, erhält man das Betadiketon 7,7-Dimethyl-1,1,1,2,2,3,3-heptafluor-4,6-octandion (FOD). Ein weiteres Beta-diketon, das als Ligand geeignet ist, ist 3-(Trifluormethyl-hydroxymethylen)-1-campher.

Besonders effizient sind die Chelatkomplexe der Seltenerdmetalle mit Liganden $L_1$, die Anionen aromatischer Carbonsäuren, wie Benzoesäure, Dipicolinsäure und Picolinsäure sind.

Die Liganden $L_2$ sind neutrale Liganden, die ein oder mehrzähnig sein können. Die einzähnigen Liganden können Pyridin und dessen Derivate, Trialkyl-, Alkylphenyl- und Triphenylphosphinoxide, Dialkyl-, Alkylphenyl- und Diphenylsulfoxide, Alkyl-, Alkylphenyl- und Phenylamine sowie Alkyl-, Alkylphenyl- und Phenylphosphate sein.

Als mehrzähnige Liganden sind 2,2'Bipyridin, 2,2',6,2"Terpyridin, 1,10 Phenantrolin und N,N,N',N'-Tetramethylethylendiamin und deren Derivate geeignet.

Die Konzentration der genannten Seltenerdmetallkomplexe sollte 20 Molprozente nicht übersteigen, um die Transporteigenschaften der leitenden organischen Polymeren nicht zu beinflussen, denn die genannten Seltenerdmetall-verbindungen sind zumeist Isolatoren.

Es ist aber auch möglich, Liganden zu verwenden, die selber Transporteigenschaften haben. Solche Liganden sind beispielsweise die Carbonsäuren von Diphenylamin oder Triphenylamin wie Diphenylamin-2-carbonsäure oder Diphenylamin-2,2'-dicarbonsäure sowie Phenantrolin, Bipyridin und Terpyridin. Komplexe mit diesen Liganden sind p-Leiter.

Als Werkstoff für die Kathode werden Metalle mit niedriger Austrittsarbeit eingesetzt, da von der Kathode her Elektronen in die n-leitende Schicht injiziert werden müssen. Solche Metalle sind Aluminium, Magnesium und Legierungen von Magnesium mit Silber oder Indium sowie Calcium.

Die p- und n-leitenden Schichten können aus Lösung aufgebracht, aufgedampft oder in situ polymerisiert werden.

Die Seltenerdmetallkomplexe können, wenn sie sich verdampfen lassen, aufsublimiert werden, gegebenenfalls zusammen mit den elektrisch leitenden, organischen Monomeren.

Wenn sie zusammen mit einem elektrisch leitenden, organischen Polymeren aufgetragen werden sollen, ist es notwendig, beide Komponenten in einem gemeinsamem Lösungsmittel oder Lösungsmittelgemisch zu einer Beschichtungslösung aufzulösen .

Mit den oben genannten, erfindungsgemäßen Materialkombinationen wird ein besserer Wirkungsgrad für die Umsetzung der eingebrachten elektrischen Leistung in Licht erreicht. Diese Umsetzung beginnt, wenn die über die funktionellen Zwischenschichten abfallende Spannung einen bestimmten Schwellenwert überschritten hat. Dann werden von der Anode positive Ladungsträger, also Löcher, in die benachbarte Schicht injiziert. Ebenso werden von der Kathode negative Ladungsträger, also Elektronen, injiziert. An dem Übergang zwischen der p-leitenden und der n-leitenden Schicht erfolgt in einer mehr oder weniger engen Zone die Rekombination von Löchern und Elektronen. Die bei der Rekombination freiwerdende Energie $E_{rec}$ ergibt sich zu:

$$E_{rec} = I-P_+-A-P_- \approx I-A-2P$$

Hierbei ist I die molekulare Ionisationsenergie des Löcherleiters, A die molekulare Elektronenaffinität des Elektronenleiters , $P_+$ und $P_-$ die Polarisationsenergien des Lochs bzw. des Elektrons, die etwa als gleich angesehen werden können.

Durch diese Rekombinationen werden elektrisch neutrale Anregungszustände der organischen Moleküle besetzt, wenn deren Anregungsenergie gleich oder kleiner ist als die bei der Rekombination freiwerdende Energie $E_{rec}$. Normalerweise handelt es sich bei diesen Zuständen um den niedrigsten angeregten Singulettzustand $S_1$ und um den niedrigsten Triplettzustand $T_1$, der bei organischen Substanzen im allgemeinen unter $S_1$ liegt.

Diese angeregten Zustände sind nicht an einzelne Moleküle lokalisiert, sondern sie können zwischen benachbarten Molekülen ausgetauscht werden und so einige hundert Moleküllagen weit durch das Material diffundieren. Man nennt diese beweglichen Anregungszustände Excitonen. Entsprechend den beteiligten Energieniveaus gibt es Singulett und Triplett-Excitonen. Singulett-Excitonen entstehen, wenn die Spins von Elektron und Loch antiparallel standen, Triplett-Excitonen, wenn sie parallel standen. Falls sowohl das $S_1$- als auch das $T_1$-Niveau energetisch erreichbar sind, so entstehen aus Multiplizitätsgründen dreimal soviel Triplett-Excitonen wie Singulett- Excitonen.

Bei den elektrolumineszierenden Bauteilen nach dem Stand der Technik entsteht ein Lichtquant nur bei dem Übergang aus dem Singulett-Zustand des Moleküls in den Grundzustand. Der radiative Übergang vom Triplettniveau $T_1$ in den Grundzustand ist verboten. Aus diesem Grund ist die Lebensdauer des angeregten $T_1$-Zustandes sehr hoch, sodaß dann konkurrierende, strahlungslose Übergänge den $T_1$-Zustand allmählich leeren und thermische Energie dadurch frei wird.

Die ansich verbotenen strahlenden Übergänge von dem $T_1$-Zustand in den Grundzustand kann man nur bei sehr tiefen Temperaturen, etwa bei Temperaturen des flüssigen Stickstoffs, als Phosporeszenz beobachten.

Die organischen LEDs nach dem Stand der Technik nutzen nur die Singulettzustände aus und haben deshalb einen niedrigen Wirkungsgrad. Bei den bekannten organischen LEDs werden die an der Grenzfläche zur Elektrode injizierten Löcher und Elektronen bis an den Übergang zwischen p-leitendem und n-leitendem Material transportiert. Wie bei den erfindungsgemäßen elektrolumineszenten Bauteilen baut sich hier eine starke Raumladung auf und die Ladungsträger rekombinieren. Wenn sowohl der Singulettzustand als auch der Triplett-Zustand energetisch erreichbar ist, werden hierbei Singulett und Triplett-Excitonen im Verhältnis 1:3 erzeugt, die anschließend eine gewisse Strecke durch das Material diffundieren können. Die Excitonen geben ihre Energie und ihren Spin an elektrolumineszierende Emitter-Moleküle mit niedrigeren Energienivaus ab. Diese angeregten Moleküle machen dann entweder einen strahlenden Übergang in den Grundzustand, wobei das gewünschte Lumineszenzquant emittiert wird, oder es verliert die Energie in einem nichtstrahlenden Übergang, wobei diese Anregungsenergie für die Lichtausbeute verloren geht.

Der gesamte Wirkungsgrad eines solchen elektrolumineszenten Bauteils nach dem Stand der Technik setzt sich aus $\phi_{rec}$, dem Wirkungsgrad, mit dem die injizierten Ladungsträger rekombinieren, und $\phi_{rad}$, der Wahrscheinlichkeit, mit der die erzeugten Excitonen einen radiativen Übergang bewirken.

Für die Material kombinationen für elektrolumineszente Bauteile nach dem Stand der Technik ist der Gesamtwirkungsgrad demgemäß $\phi_{el} = \phi_{rec}\ 0.25\ \phi_{rad}$. Hierbei berücksichtigt der Faktor 0.25 die Produktionshäufigkeit der Singulett-Excitonen.

Die theoretische Obergrenze für die Lichtausbeute in organischen LEDs nach dem Stand der Technik ist also 25 %, wenn sowohl die Rekombination als auch der radiative Zerfall der Excitonen mit der Wahrscheinlichkeit 1 stattfinden. Die Obergrenze für LEDs nach dem Stand der Technik beruht darauf, daß nur Singulett-Excitonen zu erlaubten, radiativen Übergängen führen können.

Gemäß der Erfindung werden jedoch auch die Triplettexcitonen genutzt, indem die Möglichkeit zur Energieübertragung aus den erzeugten Triplett-Zuständen an das Seltenerdmetallion geschaffen wird.

Dazu werden werden die n- bzw. p-leitenden organischen Monomere oder Polymeren mit einem elektrolumineszierenden Material (Emitter) gekoppelt, das metallo-organischen Komplexe der Seltenerdmetalle mit niedrigen emittierenden Zuständen enthält. Das niedrigste emittierende Niveau des Seltenerdmetallions liegt dabei soweit unterhalb der Singulett- und Triplettzustände des organischen Liganden, daß kein thermisch aktivierter Rücktransfer stattfinden kann. Bei diesen Seltenerdmetallkomplexen ist zusätzlich zu den normalen Singulett-Singulettübergängen auch der Energietransfer von dem niedrigsten Triplettzustand des organischen Liganden zu dem emittierenden Niveau des zentralen Seltenerdmetallions erlaubt.

Dieser zusätzliche erlaubte Energietransfer ermöglicht es jetzt, die Triplett-Excitonen für die Lichterzeugung nutzbar zu machen. Bedingung hierfür ist die richtige Lage der Triplettzustände der verschiedenen Materialien zueinander. Für die Auswahl der erfindungsgemäßen Materialkombinationen sind nicht die absoluten Werte der energetischen Zustände sondern deren relative Lage zueinander wichtig. Der Triplettzustand, der durch Rekombination von Elektron und Loch besetzt wird, muß über dem Triplettzustand des Liganden liegen, da sonst kein Energietransfer auf die Liganden möglich ist. Wenn diese Bedingungen jedoch erfüllt sind, wirken die Moleküle des Seltenerdmetall-Komplexes als Fallen für die Triplett-Excitonen, die hier in sichtbares Licht umgesetzt werden. Die Quantenausbeute dieser Übergänge kann sehr hoch sein, z.B. liegt sie bei $Eu(ttfa)_3phen$ und $Tb(benz)_3bipy_2$ bei 50 bis 70 %.

Für den gesamten Wirkungsgrad ergibt sich daher für die erfindungsgemäßen Materialkombinationen:

$$\phi_{el} = \phi_{rec}\ 0.25\phi_{radKomplexS1} + \phi_{rec}0.75\phi_{radKomplexT1}$$

Der erste Term bezieht sich auf den von den Singulett-Excitonen stammenden Anteil. Der zweite Term gibt den erfindungsgemäß ebenfalls genutzten Anteil der Triplett-Excitonen an.

Wenn das erfindungsgemäße elektrolumineszente Bauteil aus zwei getrennten Schichten für das p- und- das

n-leitende Polymere zusammengesetzt wird und der erste angeregte Triplettzustand der Substanz einer Schicht niedriger liegt als der in der anderen Schicht, so diffundieren die Triplett-Excitonen bevorzugt in diese Schicht mit energetisch niedrigeren Triplettzuständen hinein. Analoges gilt für die Singulett-Excitonen. Nur die jeweils in diese Schicht eingebrachten Seltenerdmetall-Komplexe können als Fallen für die Excitonen wirken und die eingebrachte elektrische Energie in Photonen umsetzen. Erfindungsgemäß muß der Seltenerdmetall-Komplex mindestens einer der organischen Schichten zugesetzt werden, und zwar derjenigen, deren $T_1$-Zustand niedriger liegt.

Für die Herstellung der erfindungsgemäßen, organischen elektrolumineszenten Bauteile ergeben sich deshalb für die zweckmäßigste Anordnung der p-und der n-leitenden Schicht und der elektrolumineszierenden Schicht verschiedene Konstellationen.

**Fig.1:** $T_1^p > T_1^n$: Die Triplett-Excitonen diffundieren überwiegend in die n-leitende Schicht, diese muß deshalb die Seltenerdmetall-Komplexe als Excitonenfalle enthalten. Hierbei ist $T_1^n > T_1^L$.

**Fig. 2:** $T_1^p < T_1^n$: Die Triplett-Excitonen diffundieren überwiegend in die p-leitende Schicht, diese muß deshalb die Seltenerdmetall-Komplexe als Excitonenfalle enthalten. Hierbei ist $T_1^p > T_1^L$.

**Fig.3:** $T_1^p \approx T_1^n$: Die Triplett-Excitonen diffundieren sowohl in die p-leitende Schicht als auch in die n-leitende Schicht, diese müssen deshalb beide die Seltenerdmetall-Komplexe als Excitonenfalle enthalten. Hierbei ist $T_1^p > T_1^L$ und $T_1^n > T_1^L$.

Die genaue Lage der Singulett-, Triplett- oder emittierenden Zustände wird aus den Absorptionsspektren oder den Phosphoreszenzspektren der jeweiligen Verbindungen erhalten.

**Beispiel 1**

Auf ein mit ITO beschichtetes Glassubstrat wird bei ca. 70 upm folgende Mischung aufgeschleudert:

1 ml PVK als 2%ige Lösung in Chlorbenzol
1 ml PBD als 1 %ige Lösung in Chlorbenzol
0.1 ml $Eu(ttfa)_3phen$ als 1 %ige Lösung in Chlorbenzol

Nach dem Trocknen ist die Schichtdicke etwa 100 nm. Dann werden bei $10^{-5}$ mbar Elektroden aus Calcium, 20 nm dick, aufgedampft, die mit Aluminium, 200 nm dick, abgedeckt werden. Wenn an das ITO der positive und and das Calcium der negative Pol einer Spannungsquelle angeschlossen wird, zeigt sich ab 14 V eine helle rote Lumineszenz, die ausschließlich aus den charakteristischen Linien des Europiums besteht.

**Beispiel 2**

Auf ein mit ITO beschichtetes Glassubstrat wird folgende Schichtfolge bei etwa $10^{-5}$ mbar aufgedampft:

TPD, mit einer Schichtdicke von 50 nm als Löcherleiter
$Eu(ttfa)_3phen$ als Lumineszenzsubstanz
$Alq_3$; als Elektronenleiter, sowie
Calcium, 20 nm, und Aluminium, 200 nm, als Elektrode.

Wenn an das ITO der positive und an das Calcium der negative Pol einer Spannungsquelle angeschlossen wird, zeigt sich ab 7 V eine helle rote Lumineszenz, die ausschließlich aus den charakteristischen Linien des Europiums besteht.

**Beispiel 3**

Auf ein mit ITO beschichtetes Glassubstrat wird folgende Schichtfolge bei etwa $10^{-5}$ mbar aufgedampft:

TPD in einer Schichtdicke von 50 nm als Löcherleiter,
$Eu(ttfa)_3phen$ mit bu-PBD im Verhältnis 1:25 gemischt, in einer Schichtdicke von 50 nm als Lumineszenzsubstanz,
$Alq_3$ in einer Schichtdicke von 35 nm als Elektronenleiter sowie Calcium, 20 nm,
und Aluminium, 200 nm, als Elektrode.

Wenn an das ITO der positive und an das Calcium der negative Pol einer Spannungsquelle angeschlossen wird, zeigt sich ab 7 V eine helle rote Lumineszenz, die ausschließlich aus den charakteristischen Linien des Europiums besteht.

**Beispiel 4**

Auf ein mit ITO beschichtetes Glassubstrat wird folgende Schichtfolge bei etwa $10^{-5}$ mbar aufgedampft:

TPD in einer Schichtdicke von 50 nm als Löcherleiter,
Eu(ftfa)$_3$phen in einer Schichtdicke von 30 nm als Lumineszenzsubstanz,
Alq$_3$ in einer Schichtdicke von 30 nm als Elektronenleiter sowie
Calcium, 20 nm, und Aluminium, 200 nm, als Elektrode.

Wenn an das ITO der positive und and das Calcium der negative Pol einer Spannungsquelle angeschlossen wird, zeigt sich ab ca. 13 V eine helle rote Lumineszenz, die aussschließlich aus den charakteristischen Linien des Europiums besteht.

**Beispiel 5**

Auf ein mit ITO beschichtetes Glassubstrat wird folgende Schichtfolge bei etwa $10^{-5}$ mbar aufgedampft:

TPD 50 nm als Löcherleiter
Eu(thd)$_3$phen 30 nm als Lumineszenzsubstanz
Alq$_3$ 50 nm als Elektronenleiter.
Calcium 20 nm
Aluminium 200 nm.

Wenn an das ITO der positive und an das Calcium der negative Pol einer Spannungsquelle angeschlossen wird, zeigt sich ab 7 V zuerst eine helle grüne Lumineszenz des Alq$_3$, die nach einigen Minuten in eine helle rote Lumineszenz, die ausschließlich aus den charakteristischen Linien des Europiums besteht, umschlägt.

**Vergleichsbeispiel**

Auf ein mit ITO beschichtetes Glassubstrat wird bei ca. 70 upm folgende Mischung aufgeschleudert:

1 ml PVK als 2 % ige Lösung in Chlorbenzol
1 ml PBD als 1 % ige Lösung in Chlorbenzol
0.1 ml Tb(benz)$_3$bipy$_2$ als 1% ige Lösung in Dimethylformamid.

Nach dem Trocknen ist die Schichtdicke etwa 100 nm. Dann werden $10^{-5}$ mbar Elektroden aus Calcium, 20 nm dick, aufgedampft, die mit Aluminium, 200 nm dick, abgedeckt werden. Wenn an das ITO der positive und an das Calcium der negative Pol einer Spannungsquelle angeschlossen wird, zeigt sich ab 18 V eine sehr schwache bläuliche Lumineszenz, die aus einem breiten Untergrund und schwachen, überlagerten charakteristischen Linien des Terbiums besteht.

**Patentansprüche**

1. Organisches elektrolumineszentes Bauteil mit einem Schichtverbund aus

   a) einer Substratschicht
   b) einer ersten transparenten Elektrodenschicht,
   c) einer oder mehreren optoelektronisch funktionellen Schichten mit

      c.1) gegebenenfalls einem oder mehreren p-leitenden, organischen Materialien mit ein oder mehreren Singulett-zuständen und ein oder mehreren Triplett-Zuständen und
      c.2) einem lumineszenzierenden Material mit einem oder mehreren Komplexen eines Seltenerdmetallions mit organischen Liganden, wobei sowohl das Seltenerdmetallion einen emittierenden Zustand als auch die organischen Liganden ein oder mehrere Singulett-Zustände und ein oder mehrere Triplett-Zustände haben und
      c.3) einem oder mehreren n-leitenden, organischen Materialien mit ein oder mehreren Singulett-Zuständen und ein oder mehreren Triplett-Zuständen und

d) einer zweiten Elektrode,

dadurch gekennzeichnet,
daß der energetisch niedrigste Triplett-Zustand der Liganden niedriger als die energetisch niedrigsten Triplett-Zustände des n-leitenden und/oder des p-leitenden, organischen Materials und über dem emittierenden Zustand des Seltenerdmetallions liegt.

**2.** Organisches elektrolumineszentes Bauteil nach Anspruch 1, dadurch gekennzeichnet,
daß ein p-leitendes organisches Material und das lumineszenzierende Material in einer ersten homogenen Schicht enthalten sind und ein n-leitendes organisches Material in einer zweiten Schicht enthalten ist, wobei der niedrigste Triplett-Zustand des p-leitenden organischen Materials niedriger liegt als derjenige des n-leitenden Materials.

**3.** Organisches elektrolumineszentes Bauteil nach Anspruch 1, dadurch gekennzeichnet,
daß ein p-leitendes organisches Material in einer ersten Schicht enthalten ist und ein n-leitendes Material und das lumineszenziernde Material in einer zweiten, homogenen Schicht enthalten sind, wobei der niedrigste Triplett-Zustand des n-leitenden organischen Materials niedriger liegt als derjenige des p-leitenden Materials.

**4.** Organisches elektrolumineszentes Bauteil nach Anspruch 1, dadurch gekennzeichnet,
daß ein p-leitendes Material mit dem lumineszierenden Material in einer ersten homogenen Schicht und ein n-leitendes Material mit dem lumineszierenden Material in einer zweiten homogenen Schicht enthalten sind.

**5.** Organisches elektrolumineszentes Bauteil nach Anspruch 1, dadurch gekennzeichnet,
daß ein oder mehrere p-leitende Materialien, das elektrolumineszierende Material und ein oder mehrere n-leitende Materialien in einer homogenen Schicht enthalten sind, wobei die Redoxpotentiale der n- und der p-leitenden Materialien größer sind als die des elektrolumineszenten Materials.

**6.** Organisches, elektrolumineszentes Bauteil nach Anspruch 1, dadurch gekennzeichnet,
daß ein oder mehrere p-leitende, organische Materialien, ein oder mehrere n-leitende organische Materialien und das elektrolumineszente Material jeweils in einer separaten Schicht angeordnet sind, wobei die Schicht mit dem elektrolumineszenten Material zwischen der Schicht mit dem oder den p-leitenden Materialien und der Schicht mit dem oder den n-leitendem Materialien liegt.

**7.** Organisches elektrolumineszentes Bauteil nach Anspruch 1 bis 6, dadurch gekennzeichnet,
daß die p-leitenden organischen Materialien ein molekular dotiertes organisches Polymer, ein halbleitendes konjugiertes Polymer oder ein intrinsisch leitendes organisches Polymer oder ein p-leitendes organisches Monomer oder deren Gemische sind.

**8.** Organisches elektrolumineszentes Bauteil nach Anspruch 1 bis 6, dadurch gekennzeichnet,
daß das p-leitende, organische Material aus den organischen Liganden des Seltenerdmetallions besteht.

**9.** Organisches elektrolumineszentes Bauteil nach Anspruch 1 bis 8, dadurch gekennzeichnet,
daß die n-leitenden organischen Materialien ein molekular dotiertes organisches Polymer, ein intrinsisch leitendes organisches Polymer oder ein n-leitendes organisches Monomer oder deren Gemische sind.

**10.** Organisches elektrolumineszentes Bauteil nach Anspruch 1 bis 9, dadurch gekennzeichnet,
daß die Liganden des Seltenerdmetallions chelatisierende Sauerstoff-, Schwefel- oder Stickstoffliganden sind.

**11.** Organisches elektrolumineszentes Bauteil nach Anspruch 1 und 3, dadurch gekennzeichnet,
daß das p-leitende organische Material Poly(N-Vinylcarbazol), der Komplex des Seltenerdmetallions Europium-(III)-Phenantrolin-tri-thenoyl-trifluoro-acetylacetonat (Eu(ttfa)$_3$phen) und das n-leitende Material 2-(4-Biphenylyl)-5-phenyl-1,3,4-oxadiazol (PBD) ist.

**12.** Organisches elektrolumineszentes Bauteil nach Anspruch 1 und 6, dadurch gekennzeichnet,
daß das p-leitende organische Material Poly(N-Vinylcarbazol), der Komplex des Seltenerdmetallions Terbium(III)-di-bipyridyl-tribenzoat Tb(benz)$_3$bipy$_2$ und das n-leitende organische Material 2-(4-Biphenylyl)-5-phenyl-1,3,4-oxadiazol (PBD) ist.

## Claims

1. An organic electroluminescent component with a layer structure comprising

    a) a substrate layer,
    b) a first transparent electrode layer,
    c) one or several functional optoelectronic layer(s) with

        c1) possibly, one or several p-type organic materials with one or several singlet states and one or several triplet states,
        c2) a luminescent material with one or several complexes of a rare earth metal ion with organic ligands, in which the rare earth metal ion has an emitting state and the organic ligands have one or several singlet states and one or several triplet states, and
        c3) one or several n-type organic materials with one or several singlet states and one or several triplet states, and

    d) a second electrode,

    characterized in that the triplet state of lowest energy of the ligands is lower than the triplet states of lowest energy of the n-type and/or the p-type organic materials but higher than above the emitting state of the rare earth metal ion.

2. An organic electroluminescent component as claimed in Claim 1, characterized in that a p-type organic material and the luminescent material are present in a first, homogeneous layer, and an n-type organic material is present in a second layer, while the lowest triplet state of the p-type organic material is lower than that of the n-type material.

3. An organic electroluminescent component as claimed in Claim 1, characterized in that a p-type organic material is contained in a first layer and an n-type material and the luminescent material are contained in a second, homogeneous layer, while the lowest triplet state of the n-type organic material is lower than that of the p-type material.

4. An organic electroluminescent component as claimed in Claim 1, characterized in that a p-type material is present together with the luminescent material in a first homogenous layer, and an n-type material together with the luminescent material in a second homogenous layer.

5. An organic electroluminescent component as claimed in Claim 1, characterized in that one or several p-type materials, the electroluminescent material, and one or several n-type materials are contained in one homogeneous layer, while the redox potentials of the n- and p-type materials are greater than those of the electroluminescent material.

6. An organic electroluminescent component as claimed in Claim 1, characterized in that one or several p-type organic materials, one or several n-type organic materials, and the electro luminescent material are each arranged in a separate layer, while the layer with the electro luminescent material lies between the layer with the p-type material(s) and that with the n-type material(s).

7. An organic electroluminescent component as claimed in Claims 1 to 6, characterized in that the p-type organic materials are a molecule-doped organic polymer, a semiconducting conjugated polymer, an intrinsically conducting organic polymer, or a p-type organic monomer, or mixtures thereof.

8. An organic electroluminescent component as claimed in Claims 1 to 6, characterized in that the p-type organic material is formed by the organic ligands of the rare earth metal ion.

9. An organic electroluminescent component as claimed in Claims 1 to 8, characterized in that the n-type organic materials are a molecule-doped organic polymer, an intrinsically conducting organic polymer, or an n-type organic monomer, or mixtures thereof.

10. An organic electroluminescent component as claimed in Claims 1 to 9, characterized in that the ligands of the rare earth metal ions are chelating oxygen, sulphur, or nitrogen ligands.

**11.** An organic electroluminescent component as claimed in Claims 1 and 3, characterized in that the p-type organic material is poly(vinylcarbazole), the complex of the rare earth metal ion is europium(III)-phenanthroline-tri-thenoyltrifluoroacetylacetonate (Eu(ttfa)$_3$phene) and the n-type material is 2-(4-biphenylyl)-5phenyl-1,3,4-oxadiazole (PBD).

**12.** An organic electroluminescent component as claimed in Claims 1 and 6, characterized in that the p-type organic material is poly(N-vinylcarbazole), the complex of the rare earth metal ion is terbium(III)-di-bipyridyl-tribenzoate Tb benz)$_3$bipy$_2$, and the n-type organic material is 2-(4-biphenylyl)-5-phenyl-1,3,4-oxadiazole (PBD).

**Revendications**

**1.** Elément électroluminescent organique avec une structure en couches composée

a) d'une couche de substrat,
b) d'une première couche d'électrode transparente,
c) d'une ou plusieurs couches fonctionnelles sur le plan opto-électronique avec

c.1) éventuellement, une ou plusieurs matières organiques p-conductrices avec un ou plusieurs états singulets et un ou plusieurs états triplets et
c.2) une matière luminescente avec un ou plusieurs complexes d'un ion métallique de terre rare avec des ligands organiques, l'ion métallique de terre rare ayant un état émetteur et les ligands organiques un ou plusieurs états singulets et un ou plusieurs état triplets et
c.3) une ou plusieurs matières organiques n-conductrices avec un ou plusieurs états singulets et un ou plusieurs états triplets et

d) d'une deuxième électrode,

l'état triplet minimal énergétiquement des ligands étant inférieur aux états triplets minimaux énergétiquement des matières organiques n-conductrices et p-conductrices et se situant au-delà de l'état émetteur de l'ion métallique de terre rare.

**2.** Elément électroluminescent organique selon la revendication 1, caractérisé en ce qu'une matière organique p-conductrice et la matière luminescente sont contenues dans une première couche homogène et une matière organique n-conductrice est contenue dans une deuxième couche, l'état triplet minimal de la matière organique p-conductrice étant inférieur à celui de la matière n-conductrice.

**3.** Elément électroluminescent organique selon la revendication 1, caractérisé en ce qu'une matière organique p-conductrice est contenue dans une première couche et une matière n-conductrice et la matière luminescente sont contenues dans une deuxième couche homogène, l'état triplet minimal de la matière organique n-conductrice étant inférieur à celui de la matière p-conductrice

**4.** Elément électroluminescent organique selon la revendication 1, caractérisé en ce qu'une matière p-conductrice est contenue avec la matière électroluminescente dans une première couche homogène et une matière n-conductrice avec la matière luminescente dans une deuxième couche homogène.

**5.** Elément électroluminescent organique selon la revendication 1, caractérisé en ce qu'une ou plusieurs matières p-conductrices, la matière électroluminescente et une ou plusieurs matières n-conductrices sont contenues dans une couche homogène, le potentiel redox de matière n- et p-conductrice étant supérieur à ceux de la matière électroluminescente.

**6.** Elément électroluminescent organique selon la revendication 1, caractérisé en ce qu'une ou plusieurs matières organiques p-conductrices, une ou plusieurs matières organiques n-conductrices et la matière électroluminescente sont respectivement disposées dans une couche séparée, la couche avec la matière électroluminescente se situant entre la couche avec la ou les matières p-conductrices et la couche avec la ou les matières n-conductrices.

7. Elément électroluminescent organique selon l'une des revendications 1 à 6, caractérisé en ce que les matières organiques p-conductrices sont un polymère organique dopé sur le plan moléculaire, un polymère conjugué semi-conducteur ou un polymère organique intrinsèquement conducteur ou un monomère organique p-conducteur ou leurs mélanges.

8. Elément électroluminescent organique selon l'une des revendications 1 à 6, caractérisé en ce que la matière organique p-conductrice se compose des ligands organiques de l'ion métallique de terre rare.

9. Elément électroluminescent organique selon l'une des revendications 1 à 8, caractérisé en ce que les matières organiques n-conductrices sont un polymère organique dopé sur le plan moléculaire, un polymère organique intrinsèquement conducteur ou un monomère organique n-conducteur ou leurs mélanges.

10. Elément électroluminescent organique selon l'une des revendications 1 à 9, caractérisé en ce que les ligands de l'ion métallique de terre rare sont des ligands chélatisants d'oxygène, de soufre ou d'azote.

11. Elément électroluminescent selon l'une des revendications 1 à 3, caractérisé en ce que la matière organique p-conductrice est le poly(N-vinylcarbazol), le complexe de l'ion métallique de terre rare l'acétonate d'europium-III)-phénantroline-trithénoyltrifluoracétylique ($Eu(ttfa)_3$phène) et la matière n-conductrice le 2-(4-biphénylyl)-5-phényl-1,3,4-oxadiazole (PBD).

12. Elément électroluminescent organique selon l'une des revendications 1 à 6, caractérisé en ce que la matière organique p-conductrice est le poly(N-vinylcarbazol), le complexe de l'ion métallique de terre rare le terbium (III)-di-bipyridyltribenzoate $Tb(benz)_3bipy_2$ et la matière organique n-conductrice le 2-(4-biphénylyl)-5-phényl-1,3,4-oxadiazol (PBD).

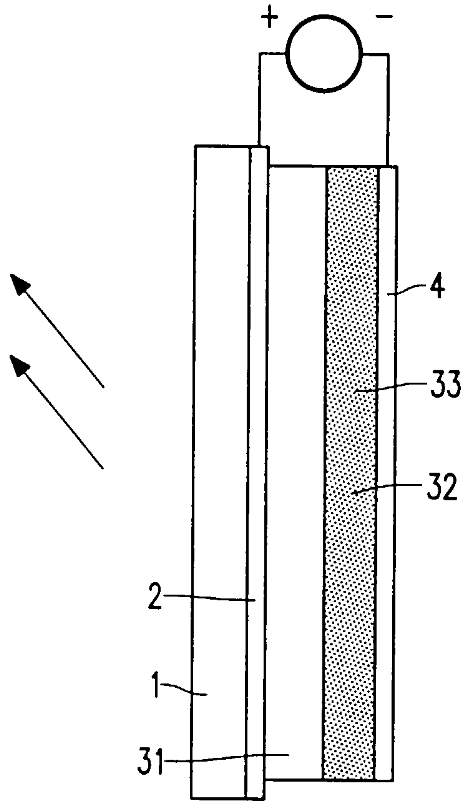


FIG. 1

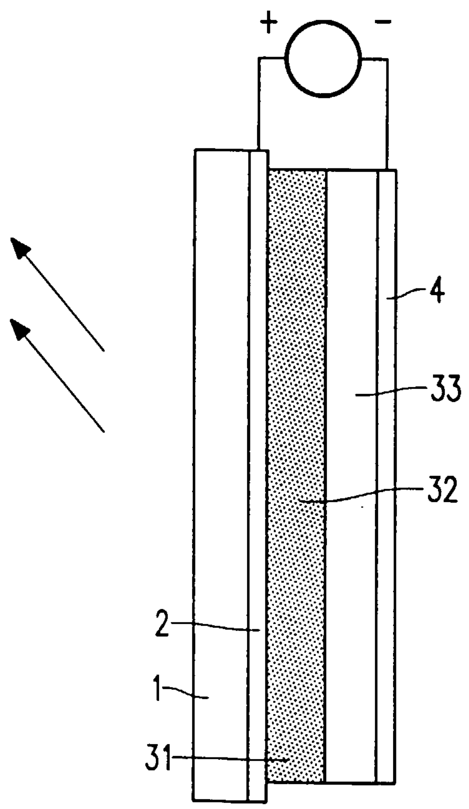


FIG. 2

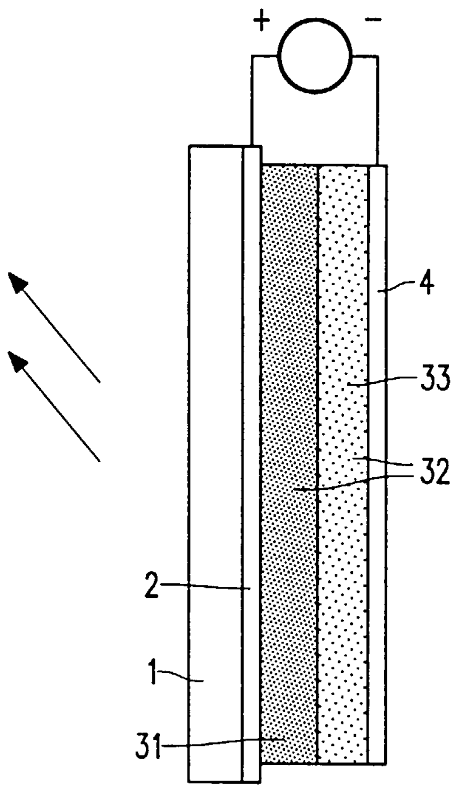


FIG. 3

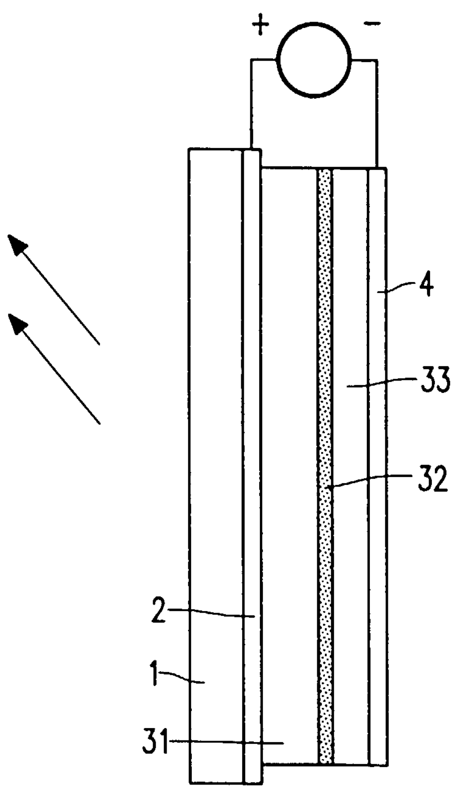


FIG. 4